# EUROPÄISCHE PATENTSCHRIFT

(11) **EP 1 720 195 B1**
(45) Veröffentlichungstag und Bekanntmachung des Hinweises auf die Patenterteilung: **12.12.2012**
(21) Anmeldenummer: 05009875.5
(22) Anmeldetag: 06.05.2005
(51) Int. Cl.: H01J 37/32

(54) **Arcunterdrückungsanordnung**
Arc suppression system
Système pour la suppression d'arcs

(43) Veröffentlichungstag der Anmeldung: 08.11.2006
(73) Patentinhaber: HÜTTINGER Elektronik GmbH + Co. KG, 79111 Freiburg (DE)
(72) Erfinder: Wiedemuth, Peter. Dr., 79336 Herbolzheim (DE); Bannwarth, Markus, 79115 Freiburg (DE); Wolf, Lothar, 79361 Sasbach (DE)
(74) Vertreter: Schmitt, Martin

(56) Entgegenhaltungen:
- EP-A- 1 441 576
- DE-A1- 10 306 347
- DE-A1- 19 834 719
- DE-A1- 19 937 859
- US-A- 5 584 972
- PATENT ABSTRACTS OF JAPAN Bd. 018, Nr. 403 (E-1584), 27. Juli 1994 (1994-07-27) & JP 06 119997 A (KYOSAN ELECTRIC MFG CO LTD), 28. April 1994 (1994-04-28)
- PATENT ABSTRACTS OF JAPAN Bd. 007, Nr. 131 (C-169), 8. Juni 1983 (1983-06-08) & JP 58 045379 A (NICHIDEN VARIAN KK), 16. März 1983 (1983-03-16)

## Beschreibung

Die Erfindung betrifft eine Arcunterdrückungsanordnung zum Löschen von Arcs in einer mit einer Wechselspannung, insbesondere MF-Wechselspannung, betriebenen Gasentladungseinrichtung, mit einer Arcunterdrückungseinrichtung, sowie eine Wechselspannungsgasentladungsanregungsanordnung.

Vakuumplasmageneratoren, die Bestandteil einer Wechselspannungsgasentladungsanregungsanordnung sein können, sind in unterschiedlichen Leistungsklassen und mit unterschiedlichen Ausgangssignalformen bekannt.

In der Vakuum-Glasbeschichtung werden beispielsweise Mittelfrequenz (MF) Generatoren mit MF-Ausgangssignal mit Leistungen zwischen 30 und 300kW eingesetzt. Das MF-Signal ist zumeist ein Sinussignal mit Frequenzen zwischen 10kHz und 200kHz. Die Ausgangsspannungen können dabei mehrere 100V bis über 1000V betragen. Zum Zünden des Plasmas liegen die Spannungen oft noch viel höher als im Normalbetrieb.

Im Plasma kann es zu kurzzeitigen und auch länger anhaltenden Überschlägen, so genannten Arcs, kommen, die unerwünscht sind. Ein Arc wird in der Regel durch ein Zusammenbrechen oder Absinken der Spannung und ein Ansteigen des Stroms, insbesondere am Ausgang des Generators oder an einer anderen Stelle im Generator erkannt. Wenn ein solcher Arc erkannt wird, muss dafür gesorgt werden, dass dieser möglichst rasch erlischt bzw. sich nicht voll entfaltet. Dazu gibt es bereits mehrere Vorschläge, siehe z.B. DE 41 27 505 C2. Hier wird beim Erkennen eines Arcs der Ausgang des Wechselstromgenerators kurzgeschlossen. Dies ist für MF-Generatoren kleinerer Leistung ein durchaus gangbarer Weg. Je größer die Leistungen werden, umso größer werden auch die Spannungen und entsprechend auch die Ströme, die ein solcher Schalter kurzschließen müsste. Das führt zu sehr großen und teuren Bauteilen. Im Extremfall müssten Bauteile in Reihe und/oder in Parallelschaltung verknüpft werden, um die hohen Spannungen und Ströme schalten zu können. Insbesondere wichtig ist es, dass beim Auftreten von Arcs der MF-Generator möglichst wenig Restenergie in den Gasentladungs-Prozess liefert. Dies wird ganz besonders bei MF-Prozessen für die Flat-Panel-Display (FPD) Fertigung gefordert. Hier kann ein Arc zu Pixelfehlern führen, wobei ein einzelner Pixelfehler die Qualität von einer großen Fläche (z.B für 19" TFT Monitore) sehr stark beeinflusst und damit einen vergleichsweise hohen Schaden anrichtet. Wenn ein Arc auftritt, muss dieser möglichst schnell erkannt und unterbrochen werden und es darf keine große Restenergie in den Arc fließen.

Bekannt ist es weiterhin, beim Erkennen eines Arcs den Generator oder Teile des Generators so abzuschalten oder anzusteuern, dass keine Energie mehr in einen Ausgangsschwingkreis des Generators fließt. Diese Vorgehensweise reicht für die FPD-Fertigung nicht aus, weil noch zu viel Restenergie im Ausgangsschwingkreis, und in den Induktivitäten eines möglicherweise vorhandenen Ausgangstransformators des Generators und der Zuleitungen übrig bleibt, die praktisch nur im Plasma (Gasentladungsprozess) und damit zum großen Teil im Arc selbst umgesetzt wird.

Aus der DE 103 06 347 A1 ist eine Leistungszufuhrregeleinheit zur Regelung der Leistungszufuhr der von einer Wechselstromquelle gelieferten Leistung auf mindestens zwei Verbraucher bekannt, wobei die Ist - Leistungszufuhr auf die Verbraucher erfasst wird, mit einer vorgegebenen Soll - Leistungszufuhr verglichen wird und bei einer Abweichung durch Zufuhr und/oder Abfuhr von Leistung zwischen der Wechselstromquelle und mindestens einem der Verbraucher die Leistungszufuhr für jeden Verbraucher angepasst wird.

In der JP 06119997 wird vorgeschlagen, auf das Erkennen eines Arcs mit der Reduzierung der Leistung, die in die Plasmakammer geliefert wird, zu reagieren.

Gemäß der JP 58045379 soll beim Auftreten eines Arcs die Spannung einer Spannungsquelle reduziert werden, um den Arc zu löschen.

Aufgabe der vorliegenden Erfindung ist es, eine Arcunterdrückungsanordnung bereitzustellen, mit der Arcs in einem Gasentladungsprozess wirkungsvoll gelöscht oder unterdrückt werden können.

Diese Aufgabe wird erfindungsgemäß durch eine Arcunterdrückungsanordnung mit den Merkmalen des Anspruchs 1 gelöst. Die elektrische Leitung kann dabei jede Art einer elektrisch leitenden Verbindung zwischen einem Wechselspannungsgenerator und einer Gasentladungseinrichtung, in einem Wechselspannungsgenerator oder in einer Gasentladungseinrichtung sein. Es ist eine die Arcunterdrückungseinrichtung ansteuernde Arcerkennungseinrichtung vorgesehen. Der steuerbare Widerstand wird im Betrieb so gesteuert, dass er im Normalbetrieb einen niedrigen Widerstandswert aufweist und im Arcerkennungsfall einen hohen Widerstandswert aufweist. Bei einem hohen Widerstandswert kann Restenergie, die im Ausgangsschwingkreis, in den Induktivitäten des Ausgangstransformators und in den Induktivitäten der Zuleitung zu dem Gasentladungsprozess, insbesondere zu Elektroden einer Gasentladungskammer, gespeichert ist, verbraucht, insbesondere in Wärme umgewandelt werden und dadurch der Gasentladungskammer fern gehalten werden. Eine (Parallel-) Kurzschlussschaltung gemäß der DE 41 27 505 C2 reicht nicht aus, das Werkstück in der Gasentladungskammer wirksam vor Arcs zu schützen, da diese keine Leistung verbraucht. Die Spannung über einem geschlossenen Schalter ist niedrig, insbesondere nahe 0V, und so werden auch bei hohen Strömen keine nennenswerten Leistungen verbraucht, das heißt der maßgebliche Anteil der Restenergie wird im Plasma und im Arc verbraucht, was höchst unerwünscht ist. Dies kann mit der erfindungsgemäßen Anordnung verhindert werden.

Erfindungsgemäβ weist der steuerbare Widerstand im arcfreien Betrieb einen geringeren Widerstandswert auf als beim Auftreten eines Arcs. Dies bedeutet, dass im Normalbetrieb durch den steuerbaren Widerstand nur wenig Leistung verbraucht wird und beim Auftreten von Arcs eine hohe Leistung verbraucht wird, die dadurch von der Gasentladungskammer fern gehalten wird. Der Arc wird dadurch nicht weiter mit Energie gespeist und kann somit erlöschen bzw. sich erst gar nicht voll entfalten.

Der steuerbare Widerstand weist im arcfreien Betrieb einen Widerstandswert < 1 Ω, insbesondere ≤ 0,1 Ω und bei Arcerkennung einen Widerstandswert > 100kΩ, insbesondere ≥ 1MΩ, auf. Der steuerbare Widerstand wird also so angesteuert, dass er bei Arcerkennung von einem niederohmigen zu einem hochohmigen Widerstandswert übergeht. Während der Übergangszeit wird dabei ein Teil der Energie aus dem Ausgangsschwingkreis des Generators verbraucht. Der Rest verbleibt im Generator.

Dabei muss der Übergang von einem niedrigen in einen hohen Widerstandswert keinesfalls gleichförmig oder linear über einer Steuersignal erfolgen, sondern kann auch nichtlinear beispielsweise zunächst langsam und dann sehr schnell in einen hohen Widerstandswert übergehen. Liegt beispielsweise die Impedanz beim Auftreten eines Arcs bei etwa 2 Ohm, so kann der steuerbare Widerstand, der im Normalbetrieb einen Widerstandswert kleiner 0,1 Ohm aufweist zunächst für wenige µs auf einen Wert gesteuert werden, der ebenfalls im Bereich von 2 Ohm liegt, z.B. 1-5 Ohm. Dann teilt sich die Energie auf den Arc und den steuerbaren Widerstand auf und es wird ein sehr hoher Anteil der Energie im Schalter verbraucht und von der Gasentladung ferngehalten.

Es kann auch vorteilhaft sein, den steuerbaren Widerstand so schnell wie möglich von Werten < 0,1 Ohm zu Werten > 1 MOhm zu verändern und so den Stromfluss zu unterbinden. Allerdings sorgen Induktivitäten z.B. des Ausgangsschwingkreises und der Zuleitungen dafür, dass ein Stromfluss erhalten bleibt. Es ist bekannt, dass ein Strom, der durch Induktivitäten fließt, sich nicht schlagartig unterbrechen lässt. Der Versuch, einen unterbrechenden Schalter in eine Stromschleife mit Induktivitäten einzubauen würde zu Spannungsüberhöhungen am öffnenden Schalter führen, die letzlich immer zu einem Überschlag am unterbrechenden Schalter führen würden. Im Prinzip kann der Strom im Ausgangsschwingkreis in diesem verbleiben und dort ausschwingen, er führt selbst nicht zwingend zu einer Spannungserhöhung über dem steuerbaren Widerstand. Aber die Zuleitungsinduktivtäten haben keine Möglichkeit den fließenden Strom abzuleiten, deswegen ist ein steuerbarer Widerstand einem öffnenden Schalter vorzuziehen.

Der steuerbare Widerstand ist auch nicht zwangsläufig linear über der Spannung oder über dem Strom. Er kann z.B. im niederohmigen Zustand einen konstanten Spannungsabfall unabhängig vom Strom aufweisen.

Bei einer bevorzugten Ausführungsform weist der zumindest eine steuerbare Widerstand einen Transistor, insbesondere IGBT, mit parallel geschalteter Diode auf. Mit einem Transistor, insbesondere einem IGBT kann ein steuerbarer Widerstand besonders einfach realisiert werden.

Vorzugsweise weist die Arcunterdrückungseinrichtung zwei in Serie geschaltete, entgegen gesetzt angeschlossene Transistoren, insbesondere IGBT, mit jeweils parallel geschalteter Diode auf. Diese Anordnung wird im Sinne der Erfindung als steuerbarer Widerstand verstanden. Im Normalbetrieb, das heißt im arcfreien Betrieb, sind beide Transistoren geschlossen und daher leitend. Wird ein Arc erkannt, werden beide Transistoren geöffnet. Da die Transistoren entgegengesetzt geschaltet sind, ist der steuerbare Widerstand für beide Halbwellen der Wechselspannung, also für zwei entgegengesetzte Stromflussrichtungen, leitend steuerbar und schaltbar. IGBTs haben den Vorteil, dass sie hohe Sperrspannungen aushalten und hohe Ströme schalten können. Die Schaltverluste von IGBTs sind bei vorliegender Anwendung besonders vorteilhaft, da die dabei verbrauchte Energie nicht in den Gasentladungsprozess gelangen kann.

Für die vorstehend beschriebene Betriebsweise ist es vorteilhaft, wenn die zu jeweils einem Transistor parallel geschaltete Diode mit zum Transistor entgegen gesetzter (antiparalleler) Durchlassrichtung angeordnet ist. Jeder IGBT leitet den Strom im geschlossenen niederohmigen Zustand in jeweils eine Richtung. In die auch im eingeschalteten Zustand sperrende Richtung des IGBT übernimmt die Diode den Stromfluss. Der Strom fließt in die eine Richtung über den ersten Transistor und die antiparallele Diode des zweiten Transistors und in die andere Richtung entsprechend über den zweiten Transistor und die antiparallele Diode des ersten Transistors.

Besonders bevorzugt ist es, wenn die Arcunterdrückungsanordnung wenigstens eine Spannungsbegrenzerschaltung aufweist, insbesondere zur Begrenzung der über dem steuerbaren Widerstand bzw. einem davon umfassten Transistor abfallenden Spannung. Durch diese Maßnahme kann verhindert werden, dass der steuerbare Widerstand oder darin enthaltene Halbleiterbauelemente, wie Transistoren, spannungsmäßig überlastet werden. Beim Erkennen eines Arcs wird der Widerstandswert des steuerbaren Widerstands schlagartig erhöht, beispielsweise indem darin enthaltene Schalter, insbesondere Transistoren, geöffnet werden. Der Strom, getrieben von den Induktivitäten der Zuleitungen zur Gasentladungskammer und/oder des Ausgangstransformators des Generators, verursacht eine hohe Spannung über dem steuerbaren Widerstand. Die Spannungsbegrenzung wirkt auf den steuerbaren Widerstand bzw. die darin enthaltenen Schalter, indem die Schalter zumindest teilweise wieder leitend gemacht werden, d.h. der Widerstandswert des steuerbaren Widerstands wieder erniedrigt wird, wobei er vorzugsweise hochohmig bleibt.

Über dem gesteuerten Widerstand fällt dadurch eine Spannung ab und es fließt ein Strom. Dadurch wird Wärme erzeugt und dadurch Leistung verbraucht. Die in Wärme umgewandelte Leistung gelangt nicht in den Gasentladungsprozess. Der Arc wird folglich erheblich reduzierter Energie gespeist und wird dadurch unterdrückt bzw. erlischt. Die Restenergie schwingt im Schwingkreis des Generators. In diesem Zusammenhang ist es vorteilhaft, wenn der steuerbare Widerstand bzw. dessen Bestandteile gekühlt werden, insbesondere durch Wasserkühlung.

Besonders wirkungsvoll ist die erfindungsgemäße Arcunterdrückungsanordnung, wenn jedem Transistor eine Spannungsbegrenzerschaltung zugeordnet ist. Da die entgegengesetzt zueinander angeschlossenen Transistoren in Serie geschaltet sind, liegen diese mit ihren Anschlüssen an jeweils unterschiedlichem Potenzial. Um jeden Transistor effektiv vor Überspannungen zu schützen, ist es daher vorteilhaft, wenn jeder Transistor seine eigene Spannungsbegrenzerschaltung aufweist. Dadurch werden die Transistoren besonders gut geschützt.

Eine besonders einfache Ausgestaltung einer Spannungsbegrenzerschaltung ergibt sich, wenn diese zumindest eine Diode, vorzugsweise mehrere in Serie geschaltete Dioden aufweist.

Vorzugsweise sind die Dioden der Spannungsbegrenzerschaltung dabei als schnelle Z-Dioden ausgebildet, wobei derartige Z-Dioden als Transildioden bekannt sind (Transil ist eine eingetragene Marke der Firma SGS-Thomson).

Bei einer besonders bevorzugten Ausgestaltung ist zumindest eine steuerbare Verbindungsanordnung zwischen zwei zu unterschiedlichen Elektroden führenden Leitungen angeordnet. Durch die Verbindungsanordnung kann ein Kurzschluss zwischen den Leitungen hergestellt werden, so dass noch vorhandene Restenergie vernichtet werden kann. Die Restenergie wird somit in einer Zusatzschaltung verbraucht und nicht im Gasentladungsprozess. Vorzugsweise ist beidseits der Arcunterdrückungseinrichtung jeweils eine steuerbare Verbindungsanordnung vorgesehen. Die Verbindungsanordnung kann durch die Arcerkennungseinrichtung angesteuert sein.

Die steuerbare Verbindungsanordnung kann zumindest einen Transistor umfassen. Ein Transistor ist ansteuerbar und durch ihn kann ein Kurzschluss erzeugt werden. Vorteilhafterweise umfasst die Verbindungsanordnung jedoch zusätzliche Elemente, wie beispielsweise Widerstände, in denen Wärme erzeugt werden kann, so dass möglichst viel Restenergie in der Verbindungsanordnung verbraucht werden kann.

In den Rahmen der Erfindung fällt außerdem eine Wechselspannungsgasentladungsanregungsanordnung, umfassend einen Wechselspannungsgenerator, insbesondere MF-Generator, und eine vorher beschriebene Arcunterdrückungsanordnung. Die Arcunterdrückungsanordnung kann dabei vollständig oder teilweise im Wechselspannungsgenerator angeordnet sein. Es ist denkbar, dass die Arcerkennungseinrichtung im Wechselspannungsgenerator angeordnet ist und die Arcunterdrückungseinrichtung außerhalb des Wechselspannungsgenerators angeordnet ist. Insbesondere kann die Arcunterdrückungseinrichtung in einer der Zuleitungen vom Generator zur Gasentladungseinrichtung angeordnet sein. Weiterhin ist es denkbar, dass die Arcunterdrückungseinrichtung in Anschlussnähe der Gasentladungseinrichtung angeordnet ist. Bevorzugt sind jedoch sämtliche Elemente im Wechselspannungsgenerator, insbesondere einem MF-Generator angeordnet, so dass der Wechselspannungsgenerator im Wesentlichen der Wechselspannungsgasentladungsanregungsanordnung entspricht.

In bevorzugter Ausgestaltung umfasst der Wechselspannungsgenerator einen Spannungsumformer und eine Spannungsumformersteuerung, die mit der Arcerkennungeinrichtung in Verbindung steht. Dadurch ist es möglich, zusätzlich zur Ansteuerung der Arcunterdrückungseinrichtung beim Erkennen eines Arcs auch die Spannungsumformersteuerung über das Auftreten eines Arcs zu informieren, so dass diese den Spannungsumformer so ansteuern kann, dass möglichst wenig Energie in den Ausgangsschwingkreis des Wechselspannungsgenerators geliefert wird. Durch diese Maßnahme kann das Fernhalten von Energie bzw. Leistung vom Gasentladungsprozess beim Auftreten eines Arcs noch wirksamer gestaltet werden.

Wenn der Spannungsumformer mit einem Ausgangsschwingkreis verbunden ist, kann eine Wechselspannung besonders einfach aus den Generator ausgekoppelt werden.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1a**: eine erste Ausführungsform einer Wechselspannungsgasentladungsanregungsanordnung, die an eine Gasentladungskammer angeschlossen ist;
- **Fig. 1b**: eine alternative Ausführungsform der Wechselspannungsgasentladungsanregungsanordnung;
- **Fig. 2**: ein Ausführungsbeispiel einer Arcunterdrückungsanordnung;
- **Fig. 3**: ein zweites Ausführungsbeispiel einer Arcunterdrückungsanordnung;
- **Fig. 4**: ein drittes Ausführungsbeispiel einer Arcunterdrückungsanordnung.

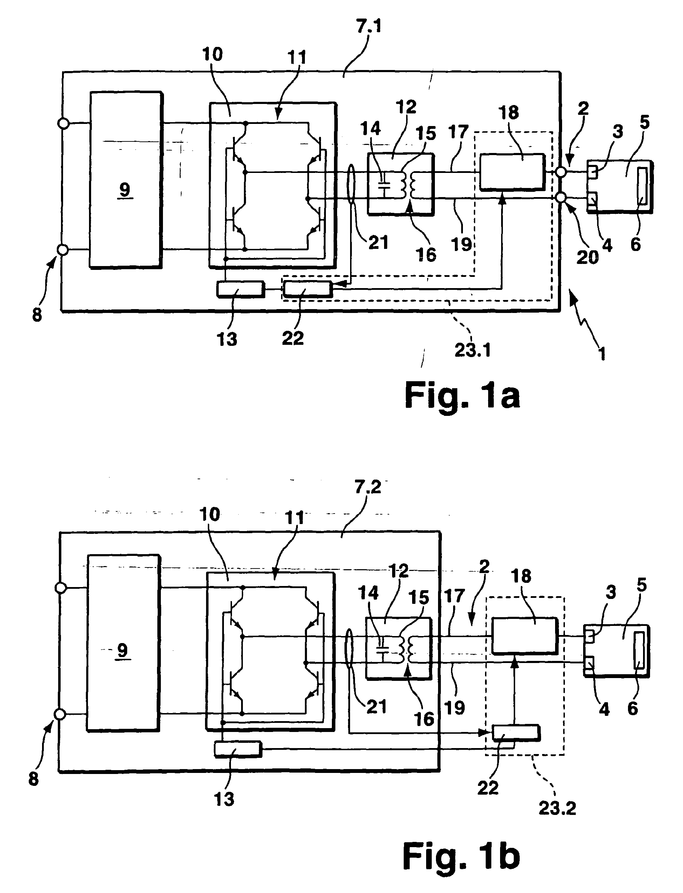

In der Fig. 1a ist eine Wechselspannungsgasentladungsanregungsanordnung 1 dargestellt, die über Zuleitungen 2 an Elektroden 3, 4 einer Gasentladungseinrichtung 5, insbesondere einer Plasmaanlage, angeschlossen ist. Die Elektroden 3, 4 sind in einer Vakuumkammer angeordnet, in der ein Werkstück 6 bearbeitet wird.

Die Wechselspannungsgasentladungsanregungsanordnung 1 umfasst einen Wechselspannungsgenerator 7.1, der einen Netzanschluss 8 aufweist. An den Netzanschlusses 8 ist ein Netzgleichrichter 9 angeschlossen, der weitere Bauelemente aufweisen kann, wie beispielsweise einen DC/DC - Wandler. Dem Netzgleichrichter 9 nachgeschaltet ist ein Spannungsumformer 10, der eine Brückenschaltung 11 umfasst. Durch den Spannungsumformer 10 wird ein Ausgangsschwingkreis 12 angesteuert. Das Ausgangssignal des Spannungsumformers 10 wird durch eine den Spannungsumformer 10 ansteuernde Spannungsumformersteuerung 13 eingestellt. Der Spannungsumformer 10 und der Ausgangsschwingkreis 12 können als Wechselspannungsquelle betrachtet werden.

Der Ausgangsschwingkreis 12 umfasst einen Kondensator 14 sowie die Streuinduktivität 15 eines Ausgangtransformators 16. Durch den Ausgangstransformator 16 kann eine galvanische Trennung durchgeführt werden. Außerdem kann er zur Spannungseinstellung verwendet werden. In die zur Elektrode 3 der Gasentladungseinrichtung 5 führenden elektrischen Leitung 17 ist eine Arcunterdrückungseinrichtung 18 in Serie geschaltet. Zwischen den elektrischen Leitungen 17, 19 sowie am Ausgangsanschluss 20 des Wechselspannungsgenerators 7.1 liegt im Normalbetrieb eine MF - Wechselspannung an.

Kommt es in der Gasentladungskammer der Gasentladungseinrichtung 5 zu einem Lichtbogen (Arc), so wirkt sich das auf Strom und/oder Spannung und/oder Leistung im Wechselstromgenerator 7.1 aus. Eine oder mehrere dieser Größen können beispielsweise durch eine Messeinrichtung 21, die zwischen Spannungsumformer 10 und Ausgangsschwingkreis 12 angeordnet ist, gemessen werden. Die Messeinrichtung 21 könnte jedoch auch an einer anderen Stelle im Wechselspannungsgenerator 7.1 oder sogar gasentladungseinrichtungsseitig angeordnet sein.

Aufgrund der durch die Messeinrichtung 21 gemessenen Größe(n) kann eine Arcerkennungseinrichtung 22 bestimmen, ob ein Arc aufgetreten oder im Entstehen ist. Die Arcerkennungseinrichtung 22 stellt ebenso wie die Arcunterdrückungseinrichtung 18 einen Teil einer Arcunterdrückungsanordnung 23.1 dar. Die Arcerkennungseinrichtung 22 steht außerdem mit der Spannungsumformersteuerung 13 in Verbindung. Die Arcunterdrückungseinrichtung 18 weist zumindest einen steuerbaren Widerstand auf, der im Normalbetrieb einen geringeren Widerstandswert einnimmt und beim Erkennen eines Arcs derart angesteuert wird, dass er einen hohen Widerstandswert einnimmt, so dass im Wechselspannungsgenerator 7.1 erzeugte Leistung in der Arcunterdrückungseinrichtung 18 verbraucht wird und nicht an die Gasentladungseinrichtung 5 geliefert wird.

Die Fig. 1b entspricht im Wesentlichen der Fig. 1a mit dem Unterschied, dass die Arcunterdrückungsanordnung 23.2 außerhalb des Wechselspannungsgenerators 7.2 angeordnet ist. Dies bedeutet, dass die Arcunterdrückungseinrichtung 18 in einer der Zuleitungen 2 zur Gasentladungseinrichtung 5 angeordnet ist.

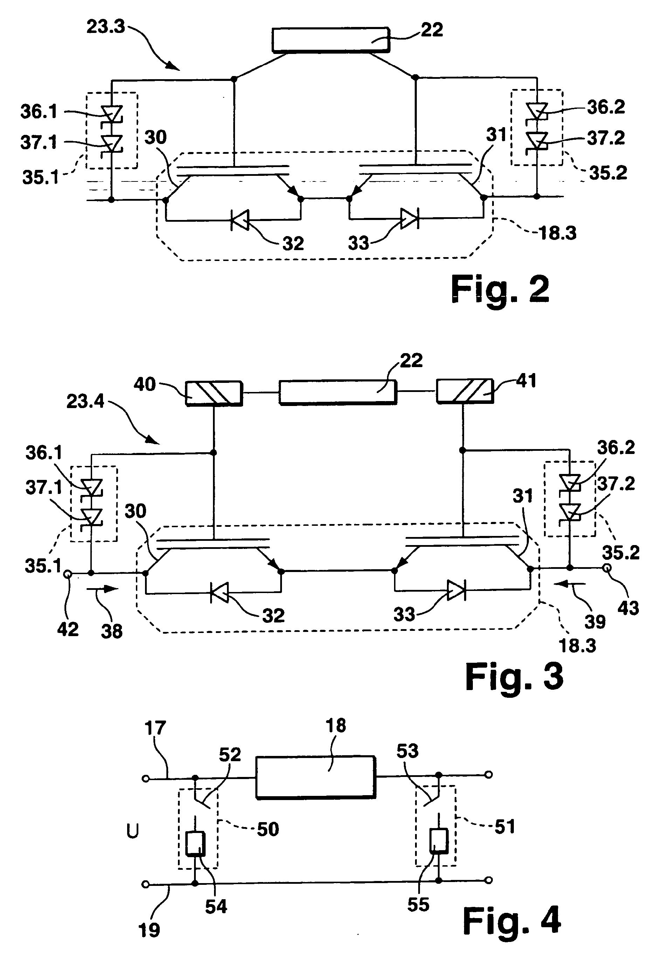

In der Fig. 2 ist eine Ausgestaltung einer Arcunterdrückungsanordnung 23.3 dargestellt. Die Arcunterdrückungsanordnung 23.3 umfasst zwei entgegengesetzt angeschlossene, in Serie geschaltete, als IGBTs ausgebildete Transistoren 30, 31, die einen steuerbaren Widerstand darstellen. Zu den Transistoren 30, 31 ist jeweils eine Diode 32, 33 parallel geschaltet, wobei die Dioden 32, 33 mit zum jeweiligen Transistor 30, 31 entgegengesetzter Durchlassrichtung angeordnet sind. Die Transistoren 30, 31 sind durch die Arcerkennungseinrichtung 22 angesteuert.

Es ist in Fig. 2 auch für jeden Transistor eine Spannungsbegrenzerschaltung 35.1 und 35.2 gezeigt, die jeweils zwei Z-Dioden 36.1, 37.1, 36.2, 37.2 umfassen. Im Normalbetrieb sind die Transistoren 30, 31 leitend geschaltet. Dies bedeutet, dass ein Stromfluss in Pfeilrichtung 38 über den Transistor 30 und die Diode 33 erfolgt und ein Stromfluss in Pfeilrichtung 39 über den Transistor 31 und die Diode 32 erfolgt. Sobald ein Bauelement verfügbar wird, das in beide Richtungen 38, 39 leitend geschaltet werden kann und dennoch als steuerbarer Widerstand betrieben werden kann, können die beiden Transistoren 30, 31 durch ein einziges Bauelement ersetzt werden.

Wird ein Arc erkannt, so steuert die Arcerkennung 22 die Transistoren 30, 31 derart an, dass diese öffnen. Ein Stromfluss in Pfeilrichtung 38 oder Pfeilrichtung 39 ist dadurch nicht mehr möglich. Sobald die Spannungsbegrenzerschaltung 35 jedoch eine Spannung feststellt, die einem vorgegebenen Wert überschreitet, werden die Transistoren 30, 31 wieder leitend geschaltet, so dass zusätzlich zu der im Arcerkennungsfall über den Transistoren 30, 31 abfallenden hohen Spannung ein Strom fließt und Leistung verbraucht wird.

Beim Ausführungsbeispiel einer Arcunterdrückungsanordnung 23.4 der Fig. 3 ist zwischen die Arcerkennungseinrichtung 22 und die Transistoren 30, 31 jeweils eine galvanische Trennung 40, 41 geschaltet. Dadurch wird dem Umstand Rechnung getragen, dass die Transistoren 30, 31 mit ihren Anschlüssen 42, 43 im Arcerkennungsfall jeweils auf unterschiedlichem Potenzial liegen.

In der Darstellung der Fig. 4 sind beidseits der Arcunterdrückungseinrichtung 18 zusätzlich optionale steuerbare Verbindunganordnungen 50, 51 angeordnet, durch die sich die Leitungen 17, 19, an denen generatorseitig eine Wechselspannung U anliegt, verbinden, insbesondere kurzschließen, lassen. Zu diesem Zweck weisen die Verbindungsanordnungen 50, 51 als Transistoren ausgebildete schaltende Elemente 52, 53 auf. Zu den schaltenden Elementen 52, 53 ist im Ausführungsbeispiel jeweils ein Widerstand 54, 55 in Serie geschaltet, so dass bei einem Stromfluss durch die Verbindungsanordnungen 50, 51 in den Widerständen 54, 55 Leistung verbraucht wird. Dadurch kann Restenergie, die im Schwingkreis 12, im Ausgangstransformator 16 oder in den Induktivitäten der Leitungen 17,19 gespeicherte Restenergie umgewandelt bzw. verbraucht werden.

## Patentansprüche

1. Arcunterdrückungsanordnung (23.1, 23.2, 23.3, 23.4), die zum Löschen von Arcs in einer mit einer Wechselspannung (U), insbesondere MF-Wechselspannung, betriebenen Gasentladungseinrichtung (5) dient, mit einer Arcunterdrückungseinrichtung (18, 18.3), die zumindest einen steuerbaren Widerstand aufweist, der in Serienschaltung in einer von einer Wechselspannungsquelle zu einer Elektrode (3) der Gasentladungseinrichtung (5) führenden elektrischen Leitung (17) anzuordnen ist, und mit einer die Arcunterdrückungseinrichtung (18, 18.3) ansteuernden Arcerkennungseinrichtung (22), **dadurch gekennzeichnet, dass** die Arcerkennungseinrichtung (22) den steuerbaren Widerstand derart ansteuert, dass der steuerbare Widerstand im arcfreien Betrieb einen geringeren Widerstandswert aufweist als beim Auftreten eines Arcs, wobei der steuerbare Widerstand im arcfreien Betrieb einen Widerstandswert< 1 Ω, insbesondere ≤ 0,1 Ω und bei Arcerkennung einen Widerstandswert > 100kΩ, insbesondere ≥1MΩ, aufweist.

2. Arcunterdrückungsanordnung nach einem der vorhergehenden Ansprüche, wobei der zumindest eine steuerbare Widerstand einen Transistor (30, 31), insbesondere IGBT, mit parallel geschalteter Diode (32, 33) aufweist.

3. Arcunterdrückungsanordnung nach einem der vorhergehenden Ansprüche, wobei die Arcunterdrückungseinrichtung (18, 18.3) zwei in Serie geschaltete, entgegengesetzt angeschlossene Transistoren (30, 31), insbesondere IGBTs, mit jeweils parallel geschalteter Diode (32, 33) aufweist.

4. Arcunterdrückungsanordnung nach einem der Ansprüche 2 oder 3, wobei die zu jeweils einem Transistor (30, 31) parallel geschaltete Diode (32, 33) mit zum Transistor (30, 31) entgegen gesetzter Durchlassrichtung angeordnet ist.

5. Arcunterdrückungsanordnung nach einem der vorhergehenden Ansprüche, wobei die Arcunterdrückungsanordnung (23.1, 23.2, 23.3, 23.4) wenigstens eine Spannungsbegrenzerschaltung (35.1, 35.2) aufweist.

6. Arcunterdrückungsanordnung nach einem der vorhergehenden Ansprüche, wobei jedem Transistor (30, 31) eine Spannungsbegrenzerschaltung (35.1, 35.2) zugeordnet ist.

7. Arcunterdrückungsanordnung nach einem der Ansprüche 5 oder 6, wobei die Spannungsbegrenzerschaltung (35, 35.1, 35.2) zumindest eine Diode (36.1, 37.1, 36.2, 37.2), vorzugsweise mehrere in Serie geschaltete Dioden aufweist.

8. Arcunterdrückungsanordnung nach Anspruch 7 , wobei die Dioden (36.1, 37.1, 36.2, 37.2) der Spannungsbegrenzerschaltung (35.1, 35.2) als Z-Dioden ausgebildet sind.

9. Arcunterdrückungsanordnung nach einem der vorhergehenden Ansprüche, wobei die Arcuntudrückungsanordunung zumindest eine steuerbare Verbindungsanordnung (50, 51) aufweist, die zwischen zwei zu unterschiedlichen Elektroden (3, 4) führenden Leitungen (17,19) anzuordnen ist.

10. Arcunterdrückungsanordnung nach einem der vorhergehenden Ansprüche, wobei beidseits der Arcunterdrückungseinrichtung (18, 18.3) jeweils eine steuerbare Verbindungsanordnung (50, 51) vorgesehen ist.

11. Arcunterdrückungsanordnung nach einem der Ansprüche 9 oder 10, wobei die steuerbare Verbindungsanordnung (50, 51) zumindest einen Transistor (52, 53) umfasst.

12. Wechselspannungsgasentladungsanregungsanordnung (1), umfassend einen Wechselspannungsgenerator (7.1, 7.2), insbesondere MF-Generator, und eine Arcunterdrückungsanordnung (23.1, 23.2, 23.3, 23.4) nach einem der vorhergehenden Ansprüche.

13. Wechselspannungsgsentladungsanregungsanordnung nach Anspruch 12, wobei der Wechselspannungsgenerator (7.1, 7.2) einen Spannungsumformer (10) und eine Spannungsumformersteuerung (13) umfasst, die mit der Arcerkennungseinrichtung (22) in Verbindung steht.

14. Wechselspannungsgasentladungsanregungsanordnung nach Anspruch 12 oder 13, wobei der Spannungsumformer (10) mit einem Ausgangsschwingkreis (12) verbunden ist.

15. Wechselspannungsgasentladungsanregungsanordnung nach einem der Ansprüche 12 bis 14, wobei die Spannungsumformersteuerung (13) den Spannungsumformer (10) bei Erkennen eines Arcs durch die Arcerkennungseinrichtung (22) derart ansteuert, dass der Spannungsumformer (10) keine Energie in den Ausgangsschwingkreis (12) liefert.

## Claims

1. Arc suppression arrangement (23.1, 23.2, 23.3, 23.4) for extinguishing arcs in a gas discharge device (5) which is operated with an alternating voltage (U), in particular an MF alternating voltage, having an arc suppression device (18, 18.3) which comprises at least one controllable resistor which is to be arranged in series connection in an electrical line (17) which extends from an alternating voltage source to an electrode (3) of the gas discharge device (5), and having an arc identification device (22) which controls the arc suppression device (18, 18.3), **characterised in that** the arc identification device (22) controls the controllable resistor in such a manner that the controllable resistor has a lower resistance value during arc-free operation than when an arc occurs, wherein the controllable resistor has a resistance value of < 1 Ω, in particular ≤ 0.1 Ω, during arc-free operation, and a resistance value of > 100 kΩ, in particular ≥ 1MΩ, when an arc is identified.

2. Arc suppression arrangement according to one of the preceding claims, wherein the at least one controllable resistor includes a transistor (30, 31), in particular an IGBT, having a diode (32, 33) connected in parallel.

3. Arc suppression arrangement according to any one of the preceding claims, wherein the arc suppression device (18, 18.3) has two oppositely connected transistors (30, 31), in particular IGBTs, which are connected in series and each have a diode (32, 33) which is connected in parallel.

4. Arc suppression arrangement according to one of the claims 2 or 3, wherein the diodes (32, 33), which are each connected in parallel with one transistor (30, 31), are arranged with a conducting direction opposite to that of the transistor (30, 31).

5. Arc suppression arrangement according to any one of the preceding claims, wherein the arc suppression arrangement (23.1, 23.2, 23.3, 23.4) has at least one voltage limitation circuit (35.1, 35.2).

6. Arc suppression arrangement according to any one of the preceding claims, wherein a voltage limitation circuit (35.1, 35.2) is associated with each transistor (30, 31).

7. Arc suppression arrangement according to one of the claims 5 or 6, wherein the voltage limitation circuit (35, 35.1, 35.2) has at least one diode (36.1, 37.1, 36.2, 37.2), preferably a plurality of diodes which are connected in series.

8. Arc suppression arrangement according to claim 7, wherein the diodes (36.1, 37.1, 36.2, 37.2) of the voltage limitation circuit (35.1, 35.2) are constructed as Z diodes.

9. Arc suppression arrangement according to any one of the preceding claims, wherein the arc suppression arrangement comprises at least one controllable connection arrangement (50, 51) which is to be arranged between two lines (17, 19) which extend to different electrodes (3, 4).

10. Arc suppression arrangement according to any one of the preceding claims, wherein a controllable connection arrangement (50, 51) is provided on each of the two sides of the arc suppression device (18, 18.3).

11. Arc suppression arrangement according to one of the claims 9 or 10, wherein the controllable connection arrangement (50, 51) has at least one transistor (52, 53).

12. Alternating voltage gas discharge excitation arrangement (1), comprising an alternating voltage generator (7.1, 7.2), in particular an MF generator, and an arc suppression arrangement (23.1, 23.2, 23.3, 23.4) according to any one of the preceding claims.

13. Alternating voltage gas discharge excitation arrangement according to claim 12, wherein the alternating voltage generator (7.1, 7.2) has a voltage converter (10) and a voltage converter control system (13) which is connected to the arc identification device (22).

14. Alternating voltage gas discharge excitation arrangement according to claim 12 or 13, wherein the voltage converter (10) is connected to an output oscillating circuit (12).

15. Alternating voltage gas discharge excitation arrangement according to any one of the claims 12 to 14, wherein the voltage converter control system (13) controls the voltage converter (10) when the arc identification device (22) has identified an arc in such a manner that the voltage converter (10) does not supply energy to the output oscillating circuit (12).

## Revendications

1. Système de suppression d'arcs (23.1, 23.2, 23.3, 23.4) qui sert à éteindre les arcs dans un dispositif à décharge gazeuse (5) alimenté par une tension alternative (U), en particulier une tension alternative MF, avec un dispositif de suppression d'arcs (18, 18.3) qui présente au moins une résistance commandable qui est à disposer en série dans une ligne électrique (17) conduisant d'une source de tension alternative à une électrode (3) du dispositif à décharge gazeuse (5), et avec un dispositif de détection d'arcs (22) qui commande le dispositif de suppression d'arcs (18, 18.3), **caractérisé en ce que** le dispositif de détection d'arcs (22) commande la résistance commandable de façon que la résistance commandable présente une valeur de résistance plus faible en fonctionnement sans arcs que lorsqu'un arc se produit, la résistance commandable présentant une valeur de résistance < 1 Ω, en particulier ≤ 0,1 Ω, en fonctionnement sans arcs et une valeur de résistance > 100 kΩ, en particulier ≥ 1 MΩ, lors de la détection d'un arc.

2. Système de suppression d'arcs selon une des revendications précédentes, dans lequel ladite au moins une résistance commandable présente un transistor (30, 31), en particulier un IGBT, avec une diode (32, 33) montée en parallèle.

3. Système de suppression d'arcs selon une des revendications précédentes, dans lequel le dispositif de suppression d'arcs (18, 18.3) présente deux transistors (30, 31) montés en série, connectés en opposition, en particulier des IGBT, chacun avec une diode (32, 33) montée en parallèle.

4. Système de suppression d'arcs selon une des revendications 2 ou 3, dans lequel chaque diode (32, 33) montée en parallèle sur un transistor (30, 31) est disposée avec son sens passant opposé à celui du transistor (30, 31).

5. Système de suppression d'arcs selon une des revendications précédentes, dans lequel le système de suppression d'arcs (23.1, 23.2, 23.3, 23.4) présente au moins un circuit limiteur de tension (35.1, 35.2).

6. Système de suppression d'arcs selon une des revendications précédentes, dans lequel un circuit limiteur de tension (35.1, 35.2) est associé à chaque transistor (30, 31).

7. Système de suppression d'arcs selon une des revendications 5 ou 6, dans lequel le circuit limiteur de tension (35, 35.1, 35.2) présente au moins une diode (36.1, 37.1, 36.2, 37.2), de préférence plusieurs diodes montées en série.

8. Système de suppression d'arcs selon la revendication 7, dans lequel les diodes (36.1, 37.1, 36.2, 37.2) du circuit limiteur de tension (35.1, 35.2) sont réalisées sous la forme de diodes Z.

9. Système de suppression d'arcs selon une des revendications précédentes, dans lequel le système de suppression d'arcs présente au moins un dispositif de connexion commandable (50, 51) qui est à disposer entre deux lignes (17, 19) conduisant à des électrodes différentes (3, 4).

10. Système de suppression d'arcs selon une des revendications précédentes, dans lequel un dispositif de connexion commandable (50, 51) est prévu de chaque côté du dispositif de suppression d'arcs (18, 18.3).

11. Système de suppression d'arcs selon une des revendications 9 ou 10, dans lequel le dispositif de connexion commandable (50, 51) comprend au moins un transistor (52, 53).

12. Système d'excitation de décharge gazeuse à tension alternative (1), comprenant un générateur de tension alternative (7.1, 7.2), en particulier un générateur MF, et un système de suppression d'arcs (23.1, 23.2, 23.3, 23.4) selon une des revendications précédentes.

13. Système d'excitation de décharge gazeuse à tension alternative selon la revendication 12, dans lequel le générateur de tension alternative (7.1, 7.2) comprend un convertisseur de tension (10) et une commande de convertisseur de tension (13) qui est reliée au dispositif de détection d'arcs (22).

14. Système d'excitation de décharge gazeuse à tension alternative selon la revendication 12 ou 13, dans lequel le convertisseur de tension (10) est relié à un circuit oscillant de sortie (12).

15. Système d'excitation de décharge gazeuse à tension alternative selon une des revendications 12 à 14, dans lequel, lors de la détection d'un arc par le dispositif de détection d'arcs (22), la commande de convertisseur de tension (13) commande le convertisseur de tension (10) de façon que le convertisseur de tension (10) ne délivre pas d'énergie dans le circuit oscillant de sortie (12).
